Europäisches Patentamt

European Patent Office

Office européen des brevets

(19)

(11)    EP 0 490 499 B1

(12)    EUROPEAN PATENT SPECIFICATION

(45) Date of publication and mention
     of the grant of the patent:
     **24.04.1996   Bulletin 1996/17**

(51) Int Cl.⁶: **H01L 23/58**, G11C 5/14

(21) Application number: **91310609.2**

(22) Date of filing: **18.11.1991**

(54) **Integrated circuit package with molded battery cell**

Integrierte Schaltungspackung mit eingekapselter Batteriezelle

Empaquetage à circuit intégré comprenant un élément d'une batterie encapsulé

(84) Designated Contracting States:
     **DE FR GB IT**

(30) Priority: **21.11.1990   US 617500**

(43) Date of publication of application:
     **17.06.1992   Bulletin 1992/25**

(73) Proprietor: **SGS-THOMSON
     MICROELECTRONICS, INC. (a Delaware corp.)
     Carrollton, TX 75006 (US)**

(72) Inventors:
     • **Hundt, Michael J.
       Denton County, Texas 75067 (US)**
     • **Kelappan, Krishnan
       Carrollton, Dallas 75006 (US)**

(74) Representative: **Palmer, Roger et al
     PAGE, WHITE & FARRER
     54 Doughty Street
     London WC1N 2LS (GB)**

(56) References cited:
     **EP-A- 0 171 089          EP-A- 0 171 089
     EP-A- 0 438 905          EP-A- 0 460 802
     US-A- 5 008 776**

     • **ELECTRONICS. vol. 60, no. 5, 5 March 1987, NEW
       YORK US pages 53 - 57; B.C. COLE: "Designer's
       dream machine"**
     • **PATENT ABSTRACTS OF JAPAN vol. 10, no. 367
       (E-462)(2424) 9 December 1986**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

## Description

This invention relates generally to packaging for semiconductor devices, and in particular to an integrated circuit package for encapsulating a semiconductor integrated circuit such as a memory chip and a backup battery for preserving memory data in the event of loss of main power supply.

Conventional electronic circuit packages for semiconductor integrated circuit chips are adapted to enclose and seal the chip devices, while also providing heat dissipation, structural support, electrical attachment of device leads to external pin connectors, and electrical interconnection with other devices in the package. Such packages may be formed of one or more layers of a non-conductive material, with the semiconductor chip embedded within one of the layers. Flexible metal leads are extended from an interconnect region surrounding the chip to edge mounted connector pins for connecting the device input/output terminals to a printed circuit board socket in a host electronic circuit.

An important integrated circuit product which is implemented on an IC chip encapsulated within an integrated circuit package includes a volatile semiconductor memory such as the static random access memory (SRAM) which is characterized by low power consumption and high memory cell density. The generation of valid logic signals and the retention of data in such integrated memory circuits having volatile memory cells depend in part on maintenance of power supply voltages within specified limits. In conventional integrated circuit memory devices, internal circuits sense the external source voltage being applied to determine if it is sufficient for reliable operation. In response to a low voltage condition, control signals are generated which cause active chips to be de-selected and maintained in standby condition. This is usually carried out by means of true and complement chip select signals, CS and $\overline{\text{CS}}$, respectively, which inhibit read/write operations until the low voltage condition has been corrected.

During the period that a memory chip is in the unselected condition it is necessary to maintain the charge levels of the storage capacitors in the volatile memory cells so that stored data will be retained. Otherwise, the information stored in the memory cells, including programs and data, will be lost when main power is removed. Although the loss of power does not result in memory circuit damage, the loss of stored information requires that the memory be reloaded with programs and data before processing can be reestablished.

It has been proposed to solve the data loss problem by using an additional pin terminal on memory semiconductor circuits and that the additional terminal will be supplied with backup power from a remote source to maintain the data in the memory cells. However, there are now established standardized pin patterns for most integrated circuit memories; consequently, the addition of another pin dedicated to a remote backup power supply would not be compatible with standard pin patterns, and would require a substantial redesign of existing circuits.

Accordingly, there exists a need for a semiconductor memory package for encapsulating a memory chip and a backup battery wherein the socket area and standard pin configuration are not affected, and stored data are retained despite a loss of the main power supply.

A substantial portion of the cost and size of a packaged chip is attributable to package fabrication, and two important design criteria in addition to providing a reliable electrical connection are cost effectiveness and space efficiency. A need thus exists for an improved device package for safely supporting an integrated circuit chip and a backup battery wherein the package is provided with pin connectors formed therein for plug-in compatibility with standard printed circuit board sockets, and the packaging space required for supporting the backup battery is minimized.

Some packages for integrated circuit memory devices include a battery molded within one half section of a two-part package. In that construction, a chip is loaded onto the base plate of a lead frame and wires are bonded between I/O pads and respective internal leads. The mold is heated, and molding resin is then injected into the heated mold cavity. Consequently, the lead frame and IC chip are encapsulated by the resin within one molded half section. A small battery and other discrete components, for example a crystal, are mounted within a second half section. The second selected half section includes connector pins accurately positioned for engaging finger leads in the lead frame of the first molded half section. The dual section arrangement has served well for many product applications. However, the additional height imposed by the second half section produces a package which exceeds the maximum height limit established for critical space product applications.

Accordingly, a need thus exists for an improved device package in which a semiconductor circuit device, a lead frame assembly and a backup battery are encapsulated within a single molded body of insulating material, wherein the packaging height dimension is less than the height of conventional two-part device packages which include a backup battery.

EP-A-0171089 discloses a power supply device comprising a power supply and a secondary battery cell. Power supply terminals of an integrated circuit are connected to the power supply and/or the secondary battery cell. This specification discloses a memory chip having the secondary battery cell bonded to the integrated circuit, the battery and integrated circuit being disposed on one side of a lead frame assembly.

EP-A-0460802, which is state of the art under Article 54(3) EPC, discloses an integrated circuit package which encapsulates a volatile memory chip and a backup battery for preserving data in the event of loss of main power supply. The package includes a finger lead assembly encapsulated within a body of non-conductive material, with a coplanar base support finger lead transversing an interconnect region. One terminal of the battery is welded to the base support finger lead, and the integrated circuit chip is bonded directly onto the other battery terminal by a layer of conductive epoxy.

The present invention provides an improved package for encapsulating an integrated circuit device, including a backup battery, and it overcomes the foregoing backup battery limitations by mounting the integrated circuit device onto a base plate on one side of a finger lead assembly, and by mounting an axial lead battery on the opposite side of the finger lead of a lead frame assembly. In this arrangement, the battery has positive and negative axial leads and which support the body of the battery in offset relation above the finger lead frame assembly. The integrated circuit device substrate is bonded to the underside of the base plate by a layer of adhesive. The backup battery, integrated circuit device and finger leads are totally enclosed within the molded body of the package, without altering the socket area or the pin configuration. Although the package height is increased to totally encapsulate the backup battery, the package height does not exceed the maximum limit established for critical space product applications.

The present invention also provides an electronic circuit package, comprising: a body of insulating material; a finger lead assembly encapsulated within said body of insulating material, said finger lead assembly including multiple conductive finger leads having internal end portions bordering an interconnect region, with one of said finger leads defining a positive power lead and one of said finger leads defining a negative power lead; a battery having a body, a positive power conductor and a negative power conductor encapsulated within said body of insulating material, the positive power conductor being electrically connected to the positive power lead and the negative power conductor being electrically connected to the negative power lead; and an electronic circuit device encapsulated within said body of insulating material, said electronic circuit device having positive and negative power nodes electrically connected to said positive and negative power leads respectively; characterised in that the electronic circuit package further comprises a base support plate disposed within the interconnect region, the positive and negative power conductors of the battery project axially from the body thereof, and said electronic circuit device is mounted on said base support plate on one side of the finger lead assembly and said battery overlying said base support plate on the opposite side of the finger lead assembly.

The present invention further provides a method for packaging an electronic circuit device and a battery for providing electrical power to the electronic circuit device, comprising the steps of: arranging the finger leads of a coplanar finger lead assembly in spaced relation about an interconnect region, with one of the conductive finger leads defining a first polarity power lead and one of the conductive finger leads defining a second polarity power lead; providing an electronic circuit device and a battery having a body, and positive and negative power conductors within said interconnect region; and encapsulating the electronic circuit device, battery, and finger leads within a body of insulating material; characterized in that the method further comprises the step of providing a base support plate within the interconnect region, the positive and negative power conuductors of the battery project axially from the body thereof, and the step of providing an electronic circuit device and a battery within the interconnect region comprises the steps of mounting the electronic circuit device onto the base support plate on one side of the finger lead assembly, disposing the battery on the opposite side of the finger lead assembly, and connecting the positive and negative axial power conductors of the battery to the first and second polarity power leads.

Operational features and advantages of the present invention will be appreciated by those skilled in the art upon reading the detailed description which follows with reference to the attached drawings, wherein:

FIGURE 1 is a perspective view of a lead frame assembly having an integrated circuit chip mounted onto the underside surface of a base plate and an axial lead battery supported above the lead frame assembly;

FIGURE 2 is a side sectional view of the semiconductor circuit chip battery and lead frame assembly of FIGURE 1 in a unitary molded package; and,

FIGURE 3 is a bottom plan view, partially broken away, of the integrated circuit chip, backup battery and lead frame assembly of FIGURE 1.

In the description which follows, like parts are indicated throughout the specification and drawings with the same reference numerals, respectively. By way of example, the invention is described in combination with a static random access memory (SRAM) which is implemented by monolithic CMOS/LSI techniques on an N-type silicon semiconductor chip. It will be appreciated, however, that the packaging assembly of the invention may be used to encapsulate and provide backup battery power for discrete as well as other integrated devices, and has particular utility for volatile memory integrated circuits having multiple input/output nodes. Accordingly, it should be understood that the invention in its broadest aspects may be incorporated in any moldable package which houses one or more circuit devices requiring backup power, including but not limited to discrete, micro-discrete and integrated circuit components, and hybrid combinations of discrete and integrated devices.

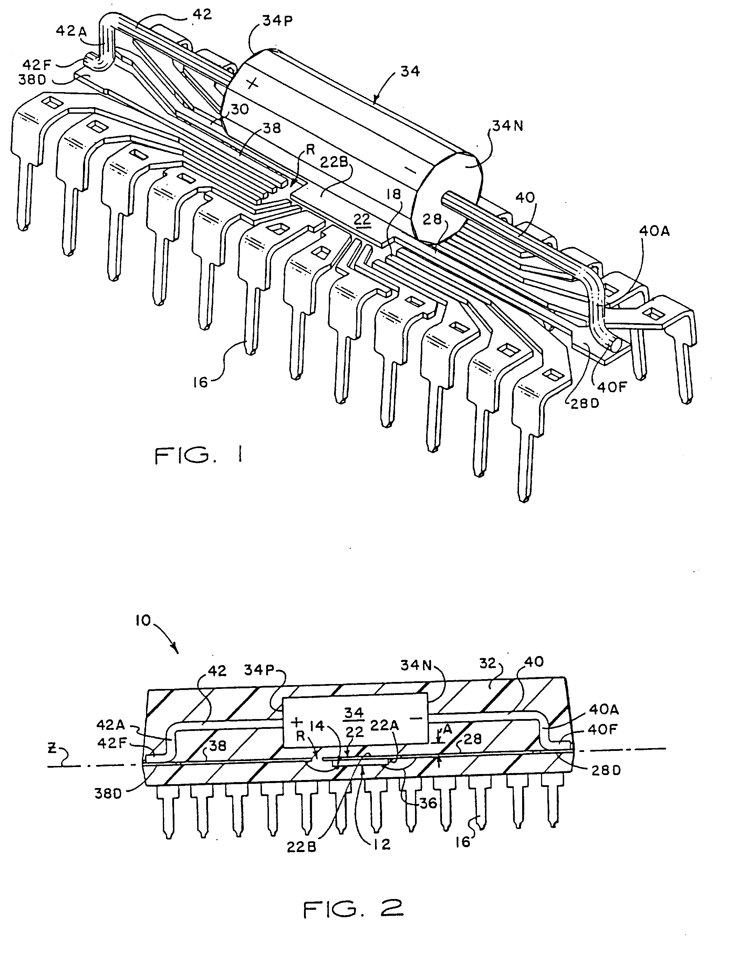

Referring now to FIGURE 1 and FIGURE 2, there is shown an exemplary semiconductor chip package 10 incorporating the present invention. The package 10 supports and encapsulates an integrated circuit chip 12 having input/output nodes 14. The IC chip 12 may be, for example a 2K x 8 static random access memory (SRAM) circuit which is characterized by low power consumption, high memory cell density and which is implemented on an N-type silicon substrate by complementary metal oxide semiconductor (CMOS) technology.

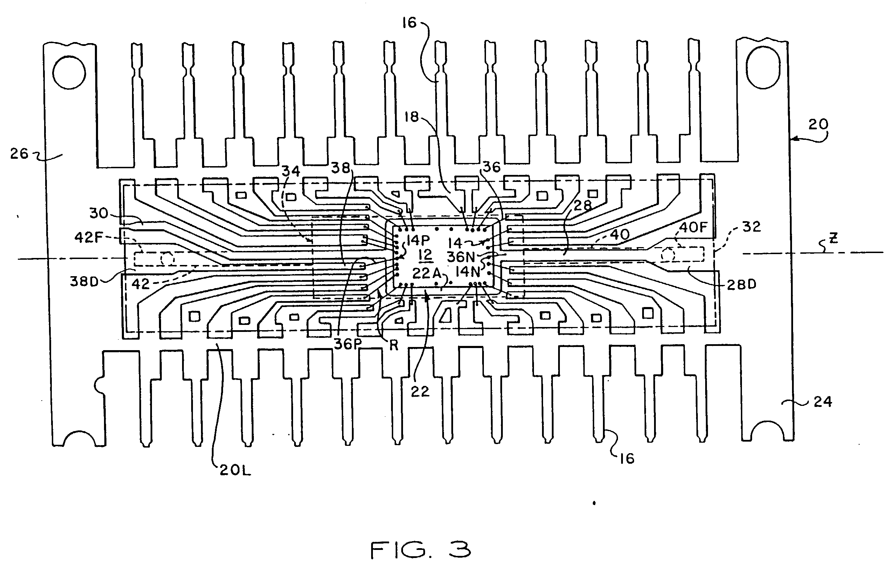

The exemplary package 10 has a conventional dual-in-line pin configuration including twenty-four external connector pins arranged in two parallel rows with 15.24 mm (600 mil) spacing along the longitudinal edges of the package. The input/output nodes 14 of the integrated circuit chip 12 are electrically connected to selected connector pins 16 by conductive finger leads 18 of a lead frame assembly 20 as shown in FIGURE 3.

The inner lead fingers 18 are radially spaced with respect to a central base plate 22 and are integrally formed with the connector pins 16. Linking segments 20L of the lead frame assembly 20 are ultimately trimmed away during manufacture, whereby each inner lead 18 is electrically connected to a single connector pin 16. Transport side rail strips 24, 26 on the outer perimeter of the lead frame 20 are also cut away during trim and form operations in the last stages of manufacture, after molding has taken place.

The inner tips of the conductive fingers 18 are radially spaced about the base plate 22 in an interconnect region R. The inner tips of the conductive fingers 18 are relatively narrow, and the fingers expand substantially as they radiate outwardly from the base plate 22. The lead frame assembly 20 includes base plate finger leads 28, 30 which extend from opposite edges of the base plate 22 in alignment with the longitudinal axis Z of the integrated circuit package 10.

The external connector pins 16 and inner finger leads 18 are initially coplanar during molding, as shown in FIGURE 3. After molding, the connector pin portions 16 are bent through a 90 degree angle along the longitudinal side surfaces of the package during the trim and form operation. However, the inner finger leads 18 and base plate 22 remain coplanar as shown in FIGURE 1 and FIGURE 2.

The semiconductor chip package 10 provides a standard external pin pattern for electrically connecting the input/output nodes 14 of the semiconductor chip 12 to a socket on a printed circuit board of a host electronic system or on some other semiconductor package. The chip package 10 includes a molded body 32 of non-conductive material, for example a polymer such as polyetherimide or epoxy resin. In this arrangement, the finger lead assembly 20, the semiconductor chip 12 and a backup battery 34 are embedded and encapsulated within the molded body 30.

Preferably, the backup battery 34 is an axial lead cell which is hermetically sealed so that its electrolyte will not evaporate when it is exposed to the elevated temperature conditions of the transfer molding procedure. Additionally, it is preferred that the battery 34 have a non-linear internal resistance which increases rapidly to a high current limiting value in response to short circuit current flow. This is desirable because the backup battery 34 will be shorted by the lead frame during assembly, and during transfer molding, until the lead frame has been trimmed. For some applications, it is desirable that the backup battery 34, in addition to being hermetically sealed and having short circuit protection, is also rechargeable so that its charge level can be restored to its rated value after assembly has been completed.

In one exemplary embodiment, the battery 34 is a 2.8 volt DC cell having a substantially cylindrical body of 4 mm (0.1575 inch) diameter and a body length of about 10.67 mm (0.42 inch). It is essential that the battery 34 be rated for high temperature duty, since it will be exposed to high temperatures during wire bonding and transfer molding. Otherwise, the electrolyte within the battery will evaporate and the battery charge will be destroyed. An example of a suitable axial lead battery 34 is a lithium-iodine cell which can be obtained from Catalyst Research Company of Baltimore, Maryland, under Model No. B35. That cell is rated at 2.8 volt DC and 35 Mah, has a 70 degree C shelf life of 10 years, and can survive elevated temperature conditions of 225 degrees C for three to five minutes without failure, which is more than adequate for the transfer molding procedure contemplated herein. The battery 34 has a positive terminal 34P and a negative terminal 34N formed on opposite ends of the battery body.

The semiconductor chip 12 is bonded to the underside surface 22A of the base plate 22 by a conductive deposit of silver-filled epoxy adhesive such as Ablebond™ 84-1. The input/output nodes 14 are electrically connected to selected conductive fingers 18 by fine gold wires 36 having a diameter of 0.033 mm (1.3 mil). Bonding of the gold wires 36 to the conductive fingers 18 and I/O nodes 14 is preferably by the conventional thermosonic ball bonding technique.

The negative and positive terminals 34N, 34P of the backup battery 34 are electrically connected to finger leads 28, 38, respectively, prior to encapsulation, preferably by resistance welding or by soldering. The finger leads 28, 38 serve as negative and positive polarity power leads for conducting current from the backup battery 34 to the interconnect region R. As can be seen in FIGURE 1, the battery 34 has negative and positive power conductors 40, 42 which support the body of the battery 34 in vertical offset relation above the lead frame assembly 20. Each power conductor is terminated by a freestanding, compliant gull-wing lead 40A, 42A, respectively, having bonding feet 40F, 42F, respectively. The dimensions of the gull-wing leads are selected to provide a battery stand-off clearance A of 0.762 mm (0.030 inch) above the base plate 22, and a total axial length (including power conductors) of about 31.75 mm (1.25 inch).

After the device 12 has been attached to the base plate mounting surface 22A, the ends of the fine gold wires 36 are then connected between the chip I/O nodes 14 and the respective finger leads 18. A gold wire 36P is bonded between the positive finger lead 38 and the positive backup voltage node 14P of chip 12. The negative backup voltage node 14N is electrically connected to the negative finger lead 28 by a gold wire 36N.

The lead frame assembly 20 is then placed in a multi-cavity split mold. The mold cavity is closed in a transfer molding machine and a non-conductive encapsulant material such as polyphenolene sulfide is injected in fine pellet form from a nozzle. The pressure at which this injection takes place is closely controlled to prevent damage to the gold wire bonds. Under the appropriate pressure and temperature, the pellets melt and flow into channels within the mold and fill the cavities around the lead frame assembly 20, thereby completely encapsulating the lead frame 20, the backup battery 34, IC chip 12 and gold wires 36. The resin is cured while still in the mold by the applied heat and pressure. Further curing takes place in an oven.

As a result of the foregoing transfer mold procedure, the package 10 is produced in the form of an elongate, generally rectangular molded body 32 of non-conductive material. After removal from the mold, the linking segments 20L between adjacent pins 16 in the lead frame assembly 20 are cut to separate and electrically isolate the pins and conductive finger leads from one another. Additionally, the transport side rails 24, 26 are also cut and separated from the molded assembly.

The lead frame 20 material preferably comprises a conventional metal alloy, such as a tin-plated nickel or iron alloy or, alternatively, a tin-plated copper alloy such as CDA 194. It will be appreciated that during assembly, the connector pins and inner conductive leads are structurally interconnected by the linking segments 20L and by the side transport side rails 24, 26, preferably stamped from a continuous metal strip. The connecting sections remain attached to the connector pins for handling purposes only and are severed during trim and form operations in the last stages of manufacture, after molding has taken place.

It will be understood that a selected one of the external pins 16 is adapted for connection to a primary power supply node which provides a voltage $V_{cc}$ which is typically at +5.0 volts DC. Similarly, another external connector pin is adapted for connection to a ground node of a host electronic system for providing a ground-reference GND. Other pins are dedicated for true and complement chip select signals, CS and $\overline{CS}$, a signal CLK for synchronously clocking data to and from the monolithic integrated circuit 12, as well as various other I/O signals which are produced by the host electronic circuit. A comparator and switching circuit (not illustrated) compares the voltage $V_{cc}$ from the primary power supply of the host electronic circuit with the voltage of the backup battery 34 and automatically connects the highest detected voltage to power the integrated circuit 12.

Because of the vertical offset A, the backup battery 34 is vertically spaced from the top surface of the base plate 22 and is centered longitudinally within the package 10. By virtue of this arrangement, the finger lead assembly, the backup battery, chip and gold wires are completely encapsulated within the compact molded body 32.

Although the invention has been described with reference to a preferred embodiment, and with reference to a package which encapsulates and provides backup battery power for an integrated circuit device, the foregoing description is not intended to be construed in a limiting sense. Various modifications of the disclosed premolded battery package as well as alternative applications thereof will be suggested to persons skilled in the art by the foregoing specification and illustrations.

## Claims

1. An electronic circuit package (10), comprising:

   a body (32) of insulating material;
   a finger lead assembly (20) encapsulated within said body (32) of insulating material, said finger lead assembly (20) including multiple conductive finger leads (18) having internal end portions bordering an interconnect region (R), with one of said finger leads (18) defining a positive power lead (38) and one of said finger leads defining a negative power lead (28);
   a battery (34) having a body, a positive power conductor (42) and a negative power conductor (40) encapsulated within said body (32) of insulating material, the positive power conductor (42) being electrically connected to the positive power lead (38) and the negative power conductor (40) being electrically connected to the negative power lead (28); and
   an electronic circuit device (12) encapsulated within said body (32) of insulating material, said electronic circuit device (12) having positive and negative power nodes (14P,14N) electrically connected to said positive and negative power leads (38,28) respectively;
   characterised in that the electronic circuit package (10) further comprises a base support plate (22) disposed within the interconnect region (R), the positive and negative power conductors (42,40) of said battery (34) project axially from the body thereof, and said electronic circuit device (12) is mounted on said base support plate (22) on one side of the finger lead assembly (20) and said battery (34) overlying said base support plate (22) on the opposite side of the finger lead assembly (20).

2. An electronic circuit package (10) as defined in claim 1, wherein said conductive finger leads (18) and said power leads (38,28) are coplanar with each other.

3. An electronic circuit package (10) as defined in claim 1 or claim 2, wherein one of said power leads (28,38) includes said base support plate (22).

4. An electronic circuit package (10) as defined in any one of claims 1 to 3, wherein said conductive finger leads (18) are radially spaced about the interconnect region (R), said body (32) of insulating material is moulded, and said electronic circuit device (12) is an integrated circuit fabricated on a semiconductor chip, said chip being mounted on and electrically connected to said base support plate (22).

5. An electronic circuit package (10) as defined in any one of claims 1 to 3, wherein said electronic circuit device (12) is an integrated circuit fabricated on a semiconductor chip, said integrated circuit having a plurality of input/output nodes (14) and a plurality of wire conductors (36) connecting said input/output nodes (14) to said conductive finger leads (18), said positive and negative power nodes (14P,14N) being electrically connected by said wire conductors (36) to the positive and negative power leads (38,28) respectively.

6. An electronic circuit package (10) as defined in any one of claims 1 to 5, wherein the positive and negative axial power conductors (42,40) each are terminated by a gull-wing lead (42A,40A) having a bonding foot (42F,40F) electrically connected to the positive and negative power leads (38,28) respectively, said battery (34) being supported in offset spaced relation from the finger lead assembly (20) by the gull-wing leads (42A,40A).

7. An electronic circuit package (10) as defined in any one of claims 1 to 6, wherein the finger lead assembly (20) has a longitudinal axis, said positive and negative power leads (38,28) extending in alignment with the longitudinal axis (Z).

8. An electronic circuit package (10) as defined in claim 7, wherein the positive and negative axial power conductors (42,40) of said battery (34) extend in substantially parallel alignment to said longitudinal axis (Z) of said finger lead assembly (20).

9. An electronic circuit package (10) as defined in any one of claims 1 to 8, wherein said battery (34) is hermetically sealed.

10. An electronic circuit package (10) as defined in any one of claims 1 to 9, wherein said battery (34) is characterised by an internal resistance which increases non-linearly so as to protect said battery against short circuit current flow.

11. An electronic circuit package (10) as defined in any one of claims 1 to 10, wherein said battery (34) is rechargeable.

12. A method for packaging an electronic circuit device (12) and a battery (34) for providing electrical power to the electronic circuit device (12), comprising the steps of:

arranging the finger leads (18) of a coplanar finger lead assembly (20) in spaced relation about an interconnect region (R), with one of the conductive finger leads (18) defining a first polarity power lead (28) and one of the conductive finger leads (18) defining a second polarity power lead (38);
providing an electronic circuit device (12) and a battery having a body, and positive and negative power conductors (42,40) within said interconnect region (R); and
encapsulating the electronic circuit device (12), battery (34), and finger leads (18) within a body (32) of insulating material;
characterized in that the method further comprises the step of providing a base support plate (22) within the interconnect region, the positive and negative power conductors (42,40) of the battery (34) project axially from the body thereof, and the step of providing an electronic circuit device (12) and a battery (34) within the interconnect region comprises the steps of mounting the electronic circuit device (12) onto the base support plate (22) on one side of the finger lead assembly (20), disposing the battery (34) on the opposite side of the finger lead assembly (20), and connecting the positive and negative axial power conductors (42,40) of the battery (34) to the first and second polarity power leads (28,38).

13. A method for packaging an electronic circuit device (12) and battery (34) as defined in claim 12, wherein the electronic circuit device (12) is an integrated circuit implemented on a semiconductor substrate, said integrated circuit having a plurality of input/output nodes (14), including the steps of mounting the semiconductor substrate on the base support plate (22), connecting the input/output nodes (14) to the conductive finger leads (18) by wire conductors (36) to the first and second power leads (28,38), respectively, on one side of the finger lead assembly (20).

14. A method as defined in claim 12 or claim 13, wherein said battery (34) is supported by its axial power conductors in offset relation to the finger lead assembly (20).

**Patentansprüche**

1. Gehäuse (10) für eine elektronische Schaltungen, das aufweist:

   einen Körper (32) aus isolierendem Material; eine Leitungsfingeranordnung (20), die innerhalb des Körpers (32) aus isolierendem Material eingekapselt ist, wobei die Leiterfingeranordnung (20) mehrere leitende Leiterfinger (18) umfaßt, die interne Endabschnitte haben, die einen Zwischenanschlußbereich (R) einfassen, wobei einer der Leiterfinger (18) eine positive Energiezufuhrleitung (38) definiert und einer der Leiterfinger eine negative Energieleitung (28) definiert;
   eine Batterie (34), die einen Körper hat, einen positiven Energieleiter (42) und einen negativen Energieleiter (40) hat, die innerhalb des Körpers (32) aus isolierendem Material eingekapselt sind, wobei der positive Energieleiter (42) elektrisch an die positive Energieleitung (38) angeschlossen ist, und der negative Energieleiter (28) elektrisch an die negative Energieleitung angeschlossen ist; und
   eine elektronische Schaltungseinrichtung (12) innerhalb des Körpers (32) aus isolierendem Material eingekapselt ist, wobei die elektronische Schaltungseinrichtung (12) positive und negative Energieknoten (14P, 14N) hat, die elektrisch an die positiven bzw. negativen Energieleitungen (38, 28) angeschlossen sind;
   **dadurch gekennzeichnet,** daß
   das Gehäuse (10) der elektronischen Schaltung ferner eine Grundtragplatte (22) aufweist, die innerhalb des Anschlußbereichs (R) angeordnet ist, wobei die positiven und negativen Energieleiter (42, 40) der Batterie (34) sich axial von deren Körper erstrecken bzw. aufwärts erstrecken, und die elektronische Schaltungseinrichtung (12) auf der Grundtragplatte (22) auf einer Seite der Leiterfingeranordnung (20) aufgebaut ist und die Batterie (34) überdeckt bzw. liegt über der Grundtragplatte (22) auf der gegenüberliegenden Seite der Leiterfingeranordnung (20).

2. Gehäuse (10) für eine elektronische Schaltung nach Anspruch 1, in dem die leitenden Leiterfinger (18) und die Energieleitungen (38, 28) coplanar zueinander sind.

3. Gehäuse (10) für eine elektronische Schaltung nach Anspruch 1 oder nach Anspruch 2, in der eine der Energieleitungen (28, 38) die Grundtragplatte (22) umfaßt.

4. Gehäuse (10) für eine elektronische Schaltung nach einem der Ansprüche 1 bis 3, in der die leitenden Leiterfinger (18) radial um den Zwischenverbindungsbereich (R) beabstandet sind, wobei der Körper (32) aus isolierendem Material geformt wird, und die elektronische Schaltungseinrichtung (12) ist eine integrierte Schaltung, die auf einem Halbleiterchip hergestellt ist, wobei der Chip auf der Grundtragplatte (22) aufgebaut und elektrisch angeschlossen ist.

5. Gehäuse (10) für eine elektronische Schaltung nach einem der Ansprüche 1 bis 3, in dem die elektronische Schaltungseinrichtung (12) eine integrierte Schaltung ist, die auf einem Halbleiterchip hergestellt ist, wobei die integrierte Schaltung mehrere Eingangs-/Ausgangsknoten (14) und mehrere Drahtkondensatoren (36) hat, die die Eingangs-/Ausgangsknoten (14) mit den leitenden Leiterfingern (18) verbinden, wobei positive und negative Energieknoten (14P, 14N) elektrisch durch die Drahtleiter (36) an die positiven bzw. negativen Energieleitungen (38, 28) angeschlossen sind.

6. Gehäuse (10) für eine elektronische Schaltung nach einem der Ansprüche 1 bis 5, in der die positiven und negativen axialen Energieleiter (42, 40) jeweils durch eine Knickflügelleitung (42A, 40A) enden, die einen Verbindungsfuß (42F, 40F) haben, der elektrisch an die positiven bzw. negativen Energieleitungen (38, 28) angeschlossen ist, wobei die Batterie (34) in einem hochgesetzten bzw. versetzten räumlichen Verhältnis durch die Leiterfingeranordnung (20) durch die Knickflügelleiter (42A, 40A) getragen sind.

7. Gehäuse (10) für eine elektronische Schaltung nach einem der Ansprüche 1 bis 6, in dem die Leiterfingeranordnung (20) eine längserstreckte Achse hat, wobei die positive und die negative Energieleitung (38, 28) in Ausrichtung zu der longitudinalen Achse (Z) erstreckt sind.

8. Gehäuse (10) für eine elektronische Schaltung nach Anspruch 7, in dem der positive und der negative Energieleiter (42, 40) der Batterie (34) im wesentlichen parallele Ausrichtung zu der longitudinalen Achse (Z) der Leiterfingeranordnung (20) erstreckt sind.

9. Gehäuse (10) für eine elektronische Schaltung nach einem der Ansprüche 1 bis 8, in dem die Batterie (34) hermetisch abgedichtet ist.

10. Gehäuse (10) für eine elektronische Schaltung nach einem der Ansprüche 1 bis 9, in dem die Batterie (34) durch einen internen Widerstand gekennzeichnet ist, der nicht linear ansteigt, um so die Batterie gegen Stromfluß bei Kurzschluß zu schützen.

**11.** Gehäuse (10) für eine elektronische Schaltung nach einem der Ansprüche 1 bis 10, in dem die Batterie (34) wiederaufladbar ist.

**12.** Verfahren zum Einpacken einer elektronischen Schaltungseinrichtung (12) und einer Batterie (34), um eine elektrische Energie für die elektronische Schaltungseinrichtung (12) zur Verfügung zu stellen, das die folgenden Schritte umfaßt:

die Leiterfinger (18) einer coplanaren Leiterfingeranordnung (20) werden in einem beabstandeten Verhältnis um einen Zwischenanschlußbereich (R) angeordnet, wobei einer der leitenden Leiterfinger (18) eine erste polare Energieleitung (28) definiert und eine der leitenden Leiterfinger (18) eine Energieleitung einer zweiten Polarität (38) bestimmt;

eine elektronische Schaltungseinrichtung (12) und eine Batterie werden zur Verfügung gestellt, die eine Batterie und positive und negative Energieleiter (42, 40) innerhalb des Zwischenanschlußbereichs (R) haben; und

die elektronische Schaltungseinrichtung (12), die Batterie (34) und die Leiterfinger (18) werden innerhalb eines Körpers (32) aus isolierendem Material eingekapselt;

**dadurch gekennzeichnet,** daß

das Verfahren ferner den Schritt aufweist, eine Grundtragplatte (22) innerhalb des Zwischenanschlußbereichs vorzusehen, wobei sich der positive und der negative Energieleiter (42, 40) der Batterie (34) axial von deren Körper erstrecken bzw. aufwärtsstrecken, und der Schritt des Vorsehens einer elektronischen Schaltungseinrichtung (12) und einer Batterie (34) innerhalb des Zwischenanschlußbereichs die Schritte umfaßt, die elektronische Schaltungseinrichtung (12) auf der Grundtragplatte (22) auf einer Seite der Leiterfingeranordnung (20) aufzubauen, die Batterie (34) auf der entgegengesetzten Seite der Leiterfingeranordnung (20) anzuordnen, und die positiven und negativen axialen Energieleiter (42, 40) der Batterie (34) an die Energieleitungen der ersten und zweiten Polarität (28, 38) anzuschließen.

**13.** Verfahren zum Verpacken bzw. Anordnen einer elektronischen Schaltungseinrichtung (12) und einer Batterie (34) in einem Gehäuse nach Anspruch 12, in dem die elektronische Schaltungseinrichtung (12) eine integrierte Schaltung ist, die auf einem Halbleitersubstrat realisiert ist, wobei die integrierte Schaltung mehrere Eingangs-/Ausgangsknoten (14) hat, das die Schritte umfaßt, das Halbleitersubstrat auf der Grundtragplatte (22) aufzubauen, wobei die Eingangs-/Ausgangsknoten (14) mit den leitenden Leiterfingern (18) über Drahtleiter (36) an die erste bzw. die zweite Energieleitung (28, 38) auf einer Seite der Leiterfingeranordnung (20) angeschlossen werden.

**14.** Verfahren nach Anspruch 12 oder Anspruch 13, in dem die Batterie (34) durch ihre axialen Energieleiter in hochgesetztem bzw. versetztem Verhältnis zu der Leiterfingeranordnung (20) getragen ist.

## Revendications

**1.** Boîtier de circuit électronique (10) comprenant :

un corps (32) de matériau isolant ;
une grille de connexion munie de doigts (20) encapsulée dans le corps (32) de matériau isolant, cette grille de connexion (20) comprenant plusieurs doigts conducteurs (18) ayant des parties d'extrémité interne qui bordent une région d'interconnexion (R), l'un des doigts conducteurs (18) définissant un conducteur d'alimentation positive (38) et un autre des doigts conducteurs définissant un conducteur d'alimentation négative (28) ;
une pile (34) comportant un corps, un fil d'alimentation positive (42) et un fil d'alimentation négative (40), encapsulée dans le corps (32) de matériau isolant, le fil d'alimentation positive (42) étant électriquement connecté au conducteur d'alimentation positive (38) et le fil d'alimentation négative (40) étant électriquement connecté au conducteur d'alimentation négative (28) ; et
un circuit électronique (12) encapsulé dans le corps (32) de matériau isolant, ce circuit électronique (12) ayant des noeuds d'alimentation positive et négative (14P, 14N) électriquement connectés aux conducteurs d'alimentation positive et négative (38, 28), respectivement ;
caractérisé en ce que le boîtier de circuit électronique (10) comprend en outre une plaque support de base (22) disposée dans la région d'interconnexion (R), les fils d'alimentation positive et négative (42, 40) de la pile (34) font saillie axialement par rapport au corps, le circuit électronique (12) est monté sur la plaque support de base (22) d'un côté de la grille de connexion (20), et la pile (34) surmonte la plaque support de base (22) du côté opposé de la grille de connexion (20).

**2.** Boîtier de circuit électronique (10) selon la revendication 1, dans lequel les doigts conducteurs (18) et les conducteurs d'alimentation (38, 28) sont coplanaires.

**3.** Boîtier de circuit électronique (10) selon la revendication 1 ou 2, dans lequel l'un des conducteurs d'alimentation (28, 38) comprend la plaque support de base (22).

4. Boîtier de circuit électronique (10) selon l'une quelconque des revendications 1 à 3, dans lequel les doigts conducteurs (18) sont radialement espacés par rapport à la région d'interconnexion (R), le corps (32) de matériau isolant est moulé, et le circuit électronique (12) est un circuit intégré fabriqué dans une puce semiconductrice, la puce étant montée sur et électriquement connectée à la plaque support de base (22).

5. Boîtier de circuit électronique (10) selon l'une quelconque des revendications 1 à 3, dans lequel le circuit électronique (12) est un circuit intégré fabriqué dans une puce semiconductrice, le circuit intégré comportant une pluralité de noeuds d'entrée/sortie (14) et une pluralité de fils conducteurs (36) reliant les noeuds d'entrée/sortie (14) aux doigts conducteurs (18), les noeuds d'alimentation positive et négative (14P, 14N) étant électriquement connectés par les fils conducteurs (36) aux conducteurs d'alimentation positive et négative (38, 28), respectivement.

6. Boîtier de circuit électronique (10) selon l'une quelconque des revendications 1 à 5, dans lequel les fils axiaux d'alimentation positive et négative (42, 40) sont chacun terminés par une portion à double flexion (42A, 40A) ayant un pied de liaison (42F, 40F) électroniquement connecté aux conducteurs d'alimentation positive et négative (38, 28), respectivement, la pile (34) étant soutenue de façon espacée de la grille de connexion (20) par les fils à double flexion (42A, 40A).

7. Boîtier de circuit électronique (10) selon l'une quelconque des revendications 1 à 6, dans lequel la grille de connexion (20) a un axe longitudinal, les conducteurs d'alimentation positive et négative (38, 28) s'étendent selon l'axe longitudinal (Z).

8. Boîtier de circuit électronique (10) selon la revendication 7, dans lequel les conducteurs axiaux d'alimentation positive et négative (42, 40) de la pile (34) s'étendent sensiblement parallèlement à l'axe longitudinal (Z) de la grille de connexion (20).

9. Boîtier de circuit électronique (10) selon l'une quelconque des revendications 1 à 8, dans lequel la pile (34) est hermétiquement scellée.

10. Boîtier de circuit électronique (10) selon l'une quelconque des revendications 1 à 9, dans lequel la pile (34) est caractérisée par une résistance interne qui croît non-linéairement de façon à protéger la pile contre un courant de court-circuit.

11. Boîtier de circuit électronique (10) selon l'une quelconque des revendications 1 à 10, dans lequel la pile (34) est rechargeable.

12. Procédé de montage d'un circuit électronique (12) et d'une pile (34) pour fournir une alimentation électrique au circuit électronique (12) comprenant les étapes suivantes :

disposer des doigts conducteurs (18) d'une grille de connexion coplanaire (20) de façon espacée d'une région d'interconnexion (R), l'un des doigts conducteurs (18) définissant un conducteur d'alimentation d'une première polarité (28) et l'un des doigts conducteurs (18) définissant un conducteur d'alimentation d'une seconde polarité (38) ;

prévoir un circuit électronique (12) et une pile comportant un corps et des fils d'alimentation positive et négative (42, 40) dans la région d'interconnexion (R) ; et

encapsuler le circuit électronique (12), la pile (34) et les doigts conducteurs (18) dans un corps (32) de matériau isolant ;

caractérisé en ce que ce procédé comprend en outre l'étape consistant à prévoir une plaque support de base (22) dans la région d'interconnexion, les fils d'alimentation positive et négative (42, 40) de la pile (34) faisant saillie axialement par rapport à son corps, et l'étape consistant à prévoir un circuit électronique (12) et une pile (34) dans la région d'interconnexion comprend les étapes de montage du circuit électronique (12) sur la plaque support de base (22) d'un côté de la grille de connexion (20), de disposition de la pile (34) du côté opposé de la grille de connexion (20), et de connexion des fils axiaux d'alimentation positive et négative (42, 40) de la pile (34) sur les conducteurs d'alimentation de première et deuxième polarités (28, 38).

13. Procédé de mise en boîtier d'un circuit électronique (12) et d'une pile (34) selon la revendication 12, dans lequel le circuit électronique (12) est un circuit intégré réalisé dans un substrat semiconducteur, le circuit intégré comportant une pluralité de noeuds d'entrée/sortie (14) comprenant les étapes consistant à monter le substrat semiconducteur sur la plaque support de base (22), à connecter les noeuds d'entrée/sortie (14) aux doigts conducteurs (18) par des fils conducteurs (36) aux premier et second conducteurs d'alimentation (28, 38), respectivement, d'un côté de la grille de connexion (20).

14. Procédé selon la revendication 12 ou 13, dans lequel la pile (34) est soutenue par ses fils d'alimentation axiaux de façon espacée par rapport à la grille de connexion (20).

FIG. 1

FIG. 2

FIG. 3